Europäisches Patentamt

European Patent Office

Office européen des brevets

(19)

(11) Publication number: **0 094 482**
**B1**

(12) **EUROPEAN PATENT SPECIFICATION**

(45) Date of publication of patent specification: **23.11.89**

(21) Application number: **83102360.1**

(22) Date of filing: **10.03.83**

(51) Int. Cl.⁴: **H 01 L 21/225, H 01 L 29/08,**
**H 01 L 29/10, H 01 L 29/72**

(54) Fabrication process for a shallow emitter, narrow intrinsic base transistor.

(30) Priority: **18.05.82 US 379535**

(43) Date of publication of application:
**23.11.83 Bulletin 83/47**

(45) Publication of the grant of the patent:
**23.11.89 Bulletin 89/47**

(84) Designated Contracting States:
**DE FR GB**

(56) References cited:
**EP-A-0 005 721**
**EP-A-0 036 634**
**US-A-4 313 255**

**IBM TECHNICAL DISCLOSURE BULLETIN, vol.
22, no. 9, February 1980, pages 4047-4051, New
York, US; T.H. YEH: "Self-aligned integrated
NPN (vertical) and PNP (lateral) structures"**

(73) Proprietor: **International Business Machines
Corporation
Old Orchard Road
Armonk, N.Y. 10504 (US)**

(72) Inventor: **Kemlage, Bernard Michael
Rt. No 1, Ulster Landing Road
Kingston New York 12401 (US)**

(74) Representative: **Hobbs, Francis John et al
IBM United Kingdom Limited Intellectual
Property Department Hursley Park
Winchester Hampshire SO21 2JN (GB)**

(56) References cited:
**IBM TECHNICAL DISCLOSURE BULLETIN, vol.
23, no. 9, February 1981, pages 4137-4139, New
York,US; C.T. HORNG et al.: "Shollow emitter
process for bipolar transistors"**

**IBM TECHNICAL DISCLOSURE BULLETIN, vol.
23, no. 2, July 1980, pages 585,586, New York,
US; N.G. ANATHA et al.: "Self-aligned poly
base process"**

Courier Press, Leamington Spa, England.

## Description

This invention relates to a method for fabricating a high performance transistor device having a shallow emitter and a narrow intrinsic base region.

The fabrication of shallow emitter, narrow intrinsic base structures in single crystal silicon substrates by ion implantation suffers from a number of problems. These problems are (1) the accidental channeling of the base dopant, that is boron, during ion implantation results in a shallow implantation concentration versus depth slope, (2) residual damage from the base implantation, (3) residual damage from emitter implantation, that is, arsenic, (4) enhanced base diffusion during the emitter activation cycle with a corresponding drop in the emitter/base junction concentration, and (5) the retardation of the base dopant by the emitter dopant during emitter activation and drive in.

The use of an ion implanted polycrystalline silicon as a dopant source for use in a semiconductor body is described in US-A-4,063,967 and in US-A-4,210,473. Arsenic doped polysilicon is used as a diffusion source for forming defect-free shallow emitters in epitaxial silicon as described in IBM Technical Disclosure Bulletin Vol. 23 No. 9 February 1981 pp 4137-4139 and in US-A-Patent 4,160,991. The processes used in the latter two references require a large number of steps to produce the desired device. The resultant device also has some inherent deficiencies.

This invention seeks to provide a method using a minimum number of process steps for fabricating a high performance bipolar transistor having a shallow emitter and a narrow intrinsic base region.

A process for forming a transistor having a shallow emitter region and a narrow intrinsic base region and an extrinsic base region includes, according to the invention, the successive steps of:

depositing a layer of polycrystalline silicon on a structure comprising a semiconductor substrate provided with a subcollector, an epitaxial layer on the semiconductor substrate, isolation regions, and an oxide layer on the epitaxial layer with an opening in the oxide layer for the formation of the extrinsic base, intrinsic base and emitter region,

thermally oxidizing the surface of the polycrystalline silicon layer,

implanting a base impurity into the polycrystalline silicon layer,

removing the surface oxide layer and the polycrystalline silicon layer from a subcollector reach-through area,

depositing a silicon nitride layer, over the structure,

depositing a silicon dioxide layer, over the structure,

opening the silicon dioxide layer, the silicon nitride layer and the thermal oxide layer to define an intrinsic base and emitter area,

thermally oxidizing the polycrystalline layer and driving the base impurity downwardly into the epitaxial layer, to form the intrinsic and extrinsic base regions of the transistor,

anisotropically etching the thermal oxide to expose the polysilicon layer in the emitter area while leaving the sidewall of the polycrystalline silicon layer covered with the thermal oxide,

ion implanting an emitter impurity into the exposed emitter area of the polycrystalline silicon layer,

thermally oxidizing the surface of the polycrystalline silicon layer in the emitter area to drive the emitter impurity inwardly into the epitaxial layer, and

opening the collector, extrinsic base and emitter contact openings and forming conductive metallurgy.

How the invention can be carried out will now be described by way of example, with reference to the accompanying drawings which illustrate successive stages in the fabrication of a high-performance shallow emitter, narrow intrinsic base transistor.

Fabrication of an NPN bipolar transistor starts with a substrate 10 of p type monocrystalline silicon material. The p type substrate 10 has a subcollector N+ diffusion made therein to form layer 12. The substrate 10 is then placed in an epitaxial growth chamber wherein an epitaxial layer 14 is grown on the surface of the diffused layer 12. The epitaxial layer may be any desired thickness, however, in order to provide a high performance transistor, the thickness should be less than about 2 micrometers. The preferred thickness of the expitaxial layer is about 1.2 micrometers.

Isolation regions 16 and 18 are openings that are filled with a suitable dielectric material such as vapor deposited silicon dioxide. P+ regions 20 can also be formed in the substrate 10 under the dielectric isolation regions 18 to act as channel stops preventing inversion. The regions 18 isolate monocrystalline silicon regions from other monocrystalline silicon regions and region 16 isolates the base-emitter region from the collector reach-through region. There are many ways in the art to form dielectric regions of this type. One process for forming these isolation regions is described in US-A-4,104,086. Alternatively, the partial dielectric isolation may be formed according to the methods described in either European patent application 82107225.3 or application 82107226.1.

A mask layer 22 is provided over the semiconductor body covering those regions designed to be collector reach-through regions and open to those designed to be the emitter, intrinsic base and extrinsic base regions. The mask layer may be a chemical vapor deposited silicon dioxide layer of about 200nm (2000Å) thick. The preferred process for depositing such a layer is a conventional low pressure, low temperature chemical vapor process using silane and oxygen at about 450°C. Alternatively, the mask layer 22 may be comprised of a combination of layers of silicon dioxide and silicon nitride or other dielectric materials. The openings in layer 22 are formed by conventional lithography and masking procedures.

A polysilicon layer 24 is deposited over the entire wafer by using preferably a low pressure chemical vapor deposition process which includes reacting silane, $SiH_4$, at a reactor pressure of about 500 millitorr ($67N/m^2$) and a reactor temperature of about 625°C for a growth rate of about 10nm/min (100Å/min). The polycrystalline silicon layer 24 makes ohmic contact to the exposed areas of the monocrystalline silicon body. Elsewhere, the polycrystalline silicon layer 24 is formed over the mask layer 22. The thickness of the polysilicon layer 24 may be 100 to 500nm (1000Å to 5000Å) with the preferred thickness being about 230nm (2300Å). The polysilicon layer 24 is then subjected to thermal oxidation to provide a silicon dioxide layer 26 between 20nm and 300nm (200Å and 3000Å) thick, with a preferred thickness of 80nm (800Å).

The structure is put into an ion implantation apparatus wherein boron is implanted into the polysilicon layer 24 to the desired doping concentration. The average doping level is between about $1 \times 10^{18}$ atoms/cc and about $1 \times 10^{21}$ atoms/cc in the polycrystalline silicon layer 24 with a preferred concentration of about $4 \times 10^{19}$ atoms/cc. During this implant, the boron is kept in the polysilicon layer 24. Photolithography and etching techniques are utilized to remove the silicon dioxide 26 and polycrystalline silicon layer 24 from all areas except the extrinsic base, intrinsic base and emitter regions.

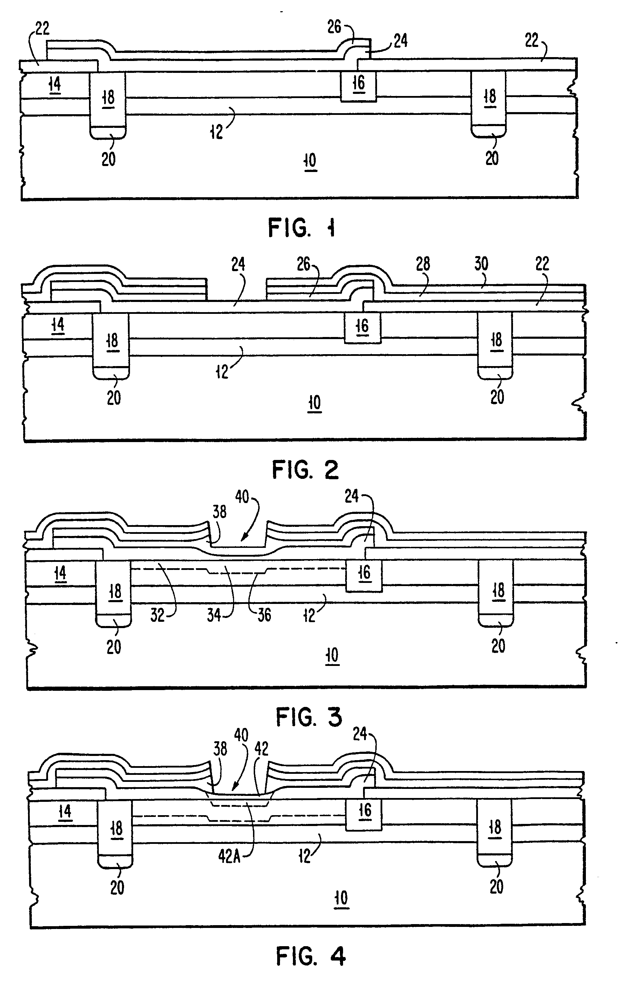

As shown in Figure 2, a layer 28 of silicon nitride, preferably 100nm (1000Å) thick, is formed over the surface of the wafer. The silicon nitride layer is formed by RF sputtering or preferably by pyrolytic deposition from a mixture of silane and ammonia in an $N_2$ ambient at 800°C. A layer of silicon dioxide 30 is then formed over the silicon nitride layer 28. The silicon dioxide layers 26 and 30 and the silicon nitride layer 28 serve as a thermal oxidation screen. Photolithography and etching techniques are then used to etch portions of the screen consisting of silicon dioxide layers 26 and 30 and silicon nitride layer 28 from the surface of the polysilicon layer 24. The etched region defines the emitter and intrinsic base regions.

As shown in Figure 3, the structure is placed in a furnace within the ion implanted polysilicon layer 24 is heated to a temperature of between 800°C to 1000°C in an oxidizing atmosphere, for example, at approximately 900°C for two minutes in oxygen, then 45 minutes in steam and then two minutes in oxygen. The effect of this heat treatment is to drive the boron about 95nm (950Å) into the epitaxial layer 14 to form the extrinsic base region 32 and the intrinsic base region 34 thereby forming a PN junction 36 which is at a depth of about 20nm to 400nm in the epitaxial layer. At the same time during the dry-wet-dry drive-in oxidation step, an oxide cover 38 is formed on the sides of the polysilicon layer 24 as a portion of the polysilicon layer 24 in the emitter opening region 40 is consumed. No polysilicon protected by the screen is consumed. This thermal oxidation step also causes an enhancement of the boron diffusivity at higher concentrations which produces a steeper slope and slightly deeper Xj in the intrinsic base region 34 and a depletion of the $C_0$ in the polycrystalline silicon layer 24 in the intrinsic base region 34. The remaining polycrystalline silicon layer 24 in the intrinsic base region 34 has a thickness of from about 20nm to 400nm (200Å to 4000Å) with a preferred thickness being about 120nm (1200Å).

As shown in Figure 4, the thermal oxide that is formed in the emitter opening region 40 is removed using an anisotropic etch such as reactive ion etch to provide sidewall coverage of polycrystalline silicon region 24 while exposing the remaining polycrystalline silicon region in the emitter opening region 40. The structure is now ready for ion-implantation of the emitter. Alternatively, an additional layer of silicon dioxide of between about 10nm to 1000nm (100Å to 10,000Å) in thickness can now be grown and removed using an anisotropic etch to increase the width of the sidewall coverage of polysilicon region 24. This layer can be silicon dioxide or a combination of silicon dioxide and silicon nitride. For a more detailed description of the sidewall process, see US-A-4,234,362. The structure is placed in a suitable ion-implantation apparatus where the emitter implantation is made. The preferred implant material is arsenic of about $1 \times 10^{15}$ to $1 \times 10^{16}$ atoms/cm$^2$ atoms/cm$^2$ applied at an energy of 5 to 50 Kev in a vacuum. This dosage gives an average arsenic doping level in the polycrystalline silicon layer 24 in the emitter opening 40 of between $5 \times 10^{19}$ and $2 \times 10^{21}$ arsenic ions/cc. The preferred conditions are $4 \times 10^{15}$ atoms/cm$^2$ at 30 Kev for a polycrystalline silicon layer of 120nm (1200Å). The resulting structure is shown in Figure 4 wherein the emitter 42 is entirely in the polysilicon layer 24. The structure is now taken from the ion implantation apparatus and put into a heat treating apparatus. The structure is heat-treated at an elevated temperature between about 800°C and 1000°C, the preferred temperature being 900°C for 60 minutes in dry oxygen and then 30 minutes in nitrogen. This causes the drive-in of the impurity from the emitter region 42 in the polysilicon layer 24 into the emitter region 42A in the single crystal epitaxial layer 14. The PN base-emitter junction is at a depth of about 10nm to 200nm in the epitaxial layer. This drive-in step consumes of the order of 40nm (400Å) of the polysilicon emitter region 40. The device is then completed by using standard lithographic techniques to open the contacts and form the metallurgy.

The method described in Figures 1 through 4 results in a number of advantages such as: there is no implant damage in the single crystal material, the intrinsic base $H_j$ is greater or equal to the extrinsic base $X_j$, the single base implant produces both the intrinsic and the extrinsic base, the polybase perimeter in the emitter region is thermally oxidized for good quality $SiO_2$/Si interface, part of the emitter/base junction is in the polysilicon, enhanced emitter diffusivity in polysilicon minimizes the base emitter metal leakage and shorts, the shallow emitter/base junctions are achieved, the partial polycrystalline silicon emitter increases the gain.

PNP bipolar device integrated circuits can alternatively be formed by simply reversing the polarities of the various elements of the transistors in the associated regions.

## Claims

1. A process for forming a transistor having a shallow emitter region and a narrow intrinsic base region and an extrinsic base region including the successive steps of:

depositing a layer of polycrystalline silicon (24) on a structure comprising a semiconductor substrate (10) provided with a subcollector (12), an epitaxial layer (14) on the semiconductor substrate, isolation regions (16, 18), and an oxide layer (22) on the epitaxial layer with an opening in the oxide layer for the formation of the extrinsic base, intrinsic base and emitter region,

thermally oxidizing the surface of the polycrystalline silicon layer,

implanting a base impurity into the polycrystalline silicon layer,

removing the surface oxide layer (26) and the polycrystalline silicon layer from a subcollector reach-through area,

depositing a silicon nitride layer (28) over the structure,

depositing a silicon dioxide layer (30) over the structure,

opening the silicon dioxide layer, the silicon nitride layer and the thermal oxide layer to define an intrinsic base and emitter area,

thermally oxidizing the polycrystalline layer and driving the base impurity downwardly into the epitaxial layer, to form the intrinsic and extrinsic base regions of the transistor,

anisotropically etching the thermal oxide to expose the polysilicon layer in the emitter area while leaving the sidewall of the polycrystalline silicon layer covered with the thermal oxide,

ion implanting an emitter impurity into the exposed emitter area of the polycrystalline silicon layer,

thermally oxidizing the surface of the polycrystalline silicon layer in the emitter area to drive the emitter impurity inwardly into the epitaxial layer, and

opening the collector, extrinsic base and emitter contact openings and forming conductive metallurgy.

2. A process as claimed in claim 1, further including, after the step of anisotropically etching the thermal oxide, depositing a layer of silicon dioxide, or a composite layer comprising silicon dioxide and silicon nitride layers, over the structure and anisotropically etching the deposited oxide layer or the composite layer, whichever is present, in the emitter area to re-expose the polycrystalline silicon layer in the emitter area while leaving an increased thickness of oxide cover on the sidewall of the polycrystalline silicon layer.

3. A process as claimed in claim 2, in which the oxide layer deposited after the step of anisotropically etching the thermal oxide, is between 10nm and 1000nm (100Å and 10,000Å) thick.

4. A process as claimed in any preceding claim, in which the polycrystalline silicon layer is 100nm to 500nm (1000Å to 5000Å) thick before it is thermally oxidised.

5. A process as claimed in claim 4, in which the polycrystalline silicon layer is about 230nm (2300Å) thick before it is thermally oxidised.

6. A process as claimed in any preceding claim, in which the base impurity is boron which is implanted into the said polycrystalline silicon layer with an average doping level of between about $1 \times 10^{18}$ and $1 \times 10^{21}$ atoms/cc.

7. A process as claimed in any preceding claim, in which the emitter impurity is arsenic with a doping level of between about $1 \times 10^{15}$ and $1 \times 10^{16}$ atoms/cm² and is mostly contained within the emitter area of the polycrystalline silicon layer.

8. A process as claimed in any preceding claim, in which the thermal oxidation of the polycrystalline silicon layer during the steps of driving the base and emitter impurities into the epitaxial layer is performed at a temperature of between about 800°C and 1000°C.

9. A process as claimed in any preceding claim, which results in the PN base-emitter junction being between about 10nm and 200nm (100Å and 2000Å) in depth into the epitaxial layer and a portion of that junction is within the said polycrystalline silicon layer.

10. A process as claimed in any preceding claim, which results in the PN base-collector junction being between about 20nm and 400nm (200Å and 4000Å) in depth into the epitaxial layer.

## Patentansprüche

1. Verfahren für die Bildung eines Transistors mit einer flachen Emitterzone und einer schmalen eigenleitenden Basiszone und einer Basisbahnzone, folgende Schritte enthaltend:

Aufbringen einer Schicht polykristallinen Siliziums (24) auf eine Struktur mit einem Halbleitersubstrat (10) mit einem Subcollector (12), einer Epitaxialschicht (14) auf dem Halbleitersubstrat, Isolierzonen (16, 18), und einer Oxidschicht (22) auf der Epitaxialschicht mit einer Öffnung in der Oxidschicht für die Bildung der Basisbahnzone, der eigenleitenden Basis- und der Emitterzone,

Wärmeoxidierung der Oberfläche der polykristallinen Siliziumschicht,

Einbringen einer Basisdotierung in die polykristalline Siliziumschicht,

Entfernung der oberflächlichen Oxidschicht (26) und der polykristallinen Silikonschicht von einer Subcollector-Durchgangszone,

Aufbringen einer Siliziumnitridschicht (28) über der Struktur,

Aufbringen einer Siliziumdioxidschicht (30) über der Struktur,

Öffnen der Siliziumdioxidschicht, der Siliziumnitridschicht und der Wärmeoxidschicht, um eine eigenleitende Basis und eine Emitterzone zu definieren,

Wärmeoxidierung der polykristallinen Schicht und Treiben der Basisdotierung nach innen in die Epitaxialschicht, um die eigenleitende Basiszone und die Basisbahnzone des Transistors zu bilden,

anisotropisches Ätzen des Wärmeoxids, um die Polysilikonschicht in der Emitterzone freizulegen, während die Seitenwand der mit dem Wärmeoxid bedeckten polykristallinen Silikonschicht entfernt wird,

Ioneneinpflanzung einer Emitterdotierung in die freigesetzte Emitterzone der polykristallinen Silikonschicht,

Wärmeoxidierung der Oberfläche der polykristallinen Silikonschicht in der Emitterzone, um die Emitterdotierung nach innen in die Epitaxialschicht zu treiben, und

Öffnen des Collectors, der Basisbahn- und Emitterkontaktöffnungen und Bildung einer leitenden Metallurgie.

2. Verfahren gemäss Anspruch 1, ferner nach dem Schritt der anisotropen Abätzung des Wärmeoxids das Auftragen einer Schicht Silikondioxid oder einer Verbundschicht aus Silikondioxid- und Silikonnitridschichten über der Struktur enthaltend, und anisotropisches Abätzen der aufgetragenen Oxidschicht bzw. der Verbundschicht, in der Emitterzone, um die polykristalline Silikonschicht in der Emitterzone wieder freizulegen, während eine grössere Dicke der Oxidschicht an der Seitenwand der polykristallinen Silikonschicht abgetragen wird.

3. Verfahren gemäss Anspruch 2, in dem die nach dem Schritt der anisotropen Abätzung des Wärmeoxids aufgetragene Oxidschicht 10 nm bis 1000 nm (100 Å und 10.000 Å) dick ist.

4. Verfahren gemäss einem der vorangehenden Ansprüche, in dem die polykristalline Siliziumschicht 100 nm bis 500 nm (1000 Å bis 5000 Å) dick ist, bevor sie wärmeoxidiert wird.

5. Verfahren gemäss Anspruch 4, in dem die polykristalline Siliziumschicht ca. 230 nm (2300 Å) dick ist, bevor sie wärmeoxidiert wird.

6. Verfahren gemäss einem der vorangehenden Ansprüche, in dem die Basisdotierung Boron ist, das in die besagte polykristalline Siliziumschicht eingebracht wird, mit einem durchschnittlichen Dotierungsniveau von $1 \times 10^{18}$ bis $1 \times 10^{21}$ Atomen/cm3.

7. Verfahren gemäss einem der vorangehenden Ansprüche, in dem die Emitterdotierung Arsen ist, mit einem Dotierungsniveau von $1 \times 10^{15}$ bis $1 \times 10^{16}$ Atomen pro cm² und zum grössten Teil in der Emitterzone der polykristallinen Siliziumschicht eingeschlossen ist.

8. Verfahren gemäss einem der vorangehenden Ansprüche, in dem die Wärmeoxidierung der polykristallinen Silikonschicht während der Schritte des Eintriebens der Basis- und Emitterdotierung in die Epitaxialschicht in einer Temperatur von ca. 800°C bis 1000°C ausgeführt wird.

9. Verfahren gemäss einem der vorangehenden Ansprüche, das eine PN Basis-Emitter-Fläche ergibt, die ca. 10 nm bis 200 nm (100 Å bis 2000 Å) tief in die Epitaxialschicht eindringt, während ein Teil dieser Verbindungsfläche innerhalb der besagten polykristallinen Silikonschicht liegt.

10. Verfahren gemäss einem der vorangehenden Ansprüche, das eine PN Basis-Collector-Verbindungsfläche ergibt, die ca. 20 nm bis 400 nm (200 Å bis 4000 Å) tief in die Epitaxialschicht eindringt.

**Revendications**

1. Procédé de fabrication d'un transistor comportant une région d'émetteur peu profonde et une région de base intrinsèque étroite et une région de base extrinsèque, qui comprend les opérations successives de:

dépôt d'une couche de silicium polycristallin (24) sur une structure comprenant un substrat semi-conducteur (10) pourvu d'un sous-collecteur (12), une couche épitaxiale (14) sur le substrat semi-conducteur, des régions d'isolation (16, 18) et une couche d'oxyde (22) sur la couche épitaxiale, une ouverture étant ménagée dans la couche d'oxyde pour la formation de la région de base extrinsèque, de base intrinsèque et d'émetteur;

oxydation thermique de la surface de la couche de silicium polycristallin;

implantation d'une impureté de base dans la couche de silicium polycristallin;

enlèvement de la couche d'oxyde de surface (26) et de la couche de silicium polycristallin dans une zone de traversée de sous-collecteur;

dépôt d'une couche de nitrure de silicium (28) sur la structure;

dépôt d'une couche de dioxyde de silicium (30) sur la structure;

ouverture de la couche de dioxyde de silicium, de la couche de nitrure de silicium et de la couche d'oxyde thermique, pour définir une zone de base intrinsèque et d'émetteur;

oxydation thermique de la couche polycristalline et enfoncement de l'impureté de base vers le bas dans la couche épitaxiale, pour former les régions de base intrinsèque et de base extrinsèque du transistor;

attaque anisotrope de l'oxyde thermique pour découvrir la couche de polysilicium dans la zone d'émetteur tout en laissant la paroi latérale de la couche de silicium polycristallin recouverte par l'oxyde thermique;

implantation d'ions d'une impureté d'émetteur dans la zone d'émetteur découverte de la couche de silicium polycristallin;

oxydation thermique de la surface de la couche de silicium polycristallin dans la zone d'émetteur, pour enfoncer l'impureté d'émetteur vers l'intérieur dans la couche épitaxiale; et

ouverture des passages de contact de collecteur, de base extrinsèque et d'émetteur, et formation d'une métallurgie conductrice.

2. Procédé suivant la revendication 1, comprenant en outre, après l'opération d'attaque isotrope de l'oxyde thermique, le dépôt d'une couche de dioxyde de silicium, ou d'une couche composite constituée de couches de dioxyde de silicium et de nitrure de silicium, sur la structure, et l'attaque anisotrope de la couche d'oxyde déposée ou de la couche composite, selon celle qui est présente, dans la zone d'émetteur de manière à redécouvrir la couche de silicium polycristallin dans la zone d'émetteur tout en laissant une plus forte épaisseur de revêtement d'oxyde sur la paroi latérale de la couche de silicium polycristallin.

3. Procédé suivant la revendication 2, dans lequel la couche d'oxyde déposée après l'opération d'attaque anisotrope de l'oxyde thermique est comprise entre 10 nm et 1000 nm d'épaisseur.

4. Procédé suivant l'une quelconque des revendications précédentes, dans lequel la couche de silicium polycristallin a une épaisseur de 100 nm à 500 nm avant son oxydation thermique.

5. Procédé suivant la revendication 4, dans lequel la couche de silicium polycristallin a une épaisseur de 230 nm environ avant son oxydation thermique.

6. Procédé suivant l'une quelconque des revendications précédentes, dans lequel l'impureté de base est du bore qui est implanté dans ladite couche de silicium polycristallin avec un niveau moyen de dopage compris entre $1 \times 10^{18}$ et $1 \times 10^{21}$ atomes/cm$^3$ environ.

7. Procédé suivant l'une quelconque des revendications précédentes, dans lequel l'impureté d'émetteur est de l'arsenic avec un niveau de dopage compris entre $1 \times 10^{15}$ et $1 \times 10^{16}$ atomes/cm$^2$ environ, et elle est principalement contenue dans la zone d'émetteur de la couche de silicium polycristallin.

8. Procédé suivant l'une quelconque des revendications précédentes, dans lequel l'oxydation thermique de la couche de silicium polycristallin pendant les opérations d'enfoncement des impuretés de base et d'émetteur dans la couche épitaxiale est effectuée à une température comprise entre 800°C et 1000°C environ.

9. Procédé suivant l'une quelconque des revendications précédentes qui a pour résultat que la jonction PN base-émetteur est à une profondeur comprise entre 10 nm et 200 nm environ dans la couche épitaxiale, et une partie de cette jonction se trouve dans la couche de silicium polycristallin.

10. Procédé suivant l'une quelconque des revendications précédentes, qui a pour résultat que la jonction PN base-collecteur est à une profondeur comprise entre 20 nm et 400 nm environ dans la couche épitaxiale.

EP 0 094 482 B1

FIG. 1

FIG. 2

FIG. 3

FIG. 4